# EUROPÄISCHE PATENTANMELDUNG

(11) **EP 2 282 339 A1**
(43) Veröffentlichungstag der Anmeldung: **09.02.2011**
(21) Anmeldenummer: 10166977.8
(22) Anmeldetag: 23.06.2010
(51) Int. Cl.: H01L 25/07

(54) **Leistungshalbleitermodul mit stromsymmetrischem Lastanschlusselement**

(30) Priorität: 01.08.2009 DE 102009035819
(71) Anmelder: SEMIKRON Elektronik GmbH & Co. KG, 90431 Nürnberg (DE)
(72) Erfinder: Lederer, Marco, 90453 Nürnberg (DE)

(57) **Zusammenfassung**

Die Erfindung beschreibt ein Leistungshalbleitermodul (1) mit mindestens zwei leistungselektronischen Teilschaltungen (50a/b/c/d) mit einem Gehäuse (3) und nach außen führenden Lastanschlusselementen (40,42,44). Hierbei ist das Lastanschlusselement (40,42,44) als Metallformkörper mit einem bandartigen Abschnitt (402) mit einer Mehrzahl von diesem Abschnitt ausgehenden Kontaktfüßen (400a/b) und mit einer Kontakteinrichtung (404) zur externen Verbindung ausgebildet, wobei der bandartige Abschnitt (402) parallel zu den Leiterbahnen eines Substrats angeordnet ist und hierbei mindestens jeweils ein erster Kontaktfuß (400a) von dem bandartigen Abschnitt (402) zu einer Leiterbahnen der jeweiligen Teilschaltung (50) reicht. Hierbei reichen ein erster Teilstrompfad (600a) von der Kontakteinrichtung (404) zu einem Verteilungsbereich (46) des bandartigen Abschnitts (402) und jeweils zweite Teilstrompfade (602a) vom Verteilungsbereich (46) zu den jeweiligen ersten Kontaktfüßen (400a). Die jeweiligen ersten Gesamtstrompfade (60a) weisen, zur symmetrischen Stromeinleitung in die jeweiligen Teilschaltungen (50a/b), gebildet sind aus dem ersten (600a) und zweiten (602a) Teilstrompfad, wobei die jeweiligen Gesamtstrompfade (60a) eine Längendifferenz von weniger als 20 von 100 zueinander auf. Dies wird erreicht indem der bandartige Abschnitt (402) hierzu mindestens eine erste Freisparung (406a) aufweist.

## Beschreibung

Die Erfindung beschreibt ein Leistungshalbleitermodul, vorzugsweise in Druckkontaktausführung zur Anordnung auf einem Kühlbauteil mit einer aus mindestens zwei Teilschaltungen bestehenden leistungselektronischen Schaltung. Jede dieser Teilschaltungen weist mindestens ein Leistungshalbleiterbauelement angeordnet auf einer Leiterbahn auf.

Einen Ausgangspunkt der Erfindung bildet ein Leistungshalbleitermodul gemäß der DE 10 2006 006 425 A1. Diese offenbart ein Leistungshalbleitermodul in Druckkontaktausführung, zur Anordnung auf einem Kühlbauteil, wobei es nach außen führende Lastanschlusselemente aufweist, die jeweils als Metallformkörper mit mindestens einem bandartigen Abschnitt und mit einer Mehrzahl von diesem ausgehenden Kontaktfüßen ausgebildet sind. Diese Lastanschlusselemente dienen mittels einer Kontakteinrichtung der externen Kontaktierung der internen leistungselektronischen Schaltung.

Es ist üblich und beispielhaft auch aus der DE 103 33 329 A1 bekannt, die leistungselektronische Schaltung eines Leistungshalbleitermoduls aus mehreren Teilschaltungen aufzubauen. Diese Teilschaltungen weisen typischerweise jeweils mindestens ein Substrat mit mindestens einem Leistungshalbleiterbauelement auf. Es kann bevorzugt sein derartige Teilschaltungen identisch auszubilden und in Reihe oder jeweils paarweise zueinander symmetrisch anzuordnen.

Der Erfindung liegt die Aufgabe zugrunde ein oben genanntes Leistungshalbleitermodul derart weiterzubilden, dass bei einer Mehrzahl von leistungselektronischen Teilschaltungen innerhalb des Leistungshalbleitermoduls die Stromzuführung symmetrisch zu allen Teilschaltungen ausgebildet ist.

Die Aufgabe wird erfindungsgemäß gelöst, durch die Merkmale des Anspruchs 1. Bevorzugte Ausführungsformen sind in den abhängigen Ansprüchen beschrieben.

Der erfinderische Gedanke geht aus von einem Leistungshalbleitermodul zur Anordnung auf einem Kühlbauteil. Das Leistungshalbleitermodul weist hierbei eine interne leistungselektronische Schaltung auf, die aus mindestens zwei Teilschaltungen besteht. Vorzugsweise weist jede dieser Teilschaltungen ein Substrat mit elektrisch voneinander isolierten Leiterbahnen mit Lastpotential auf. Auf mindestens einer dieser Leiterbahnen jeder Teilschaltung ist mindestens ein Leistungshalbleiterbauelement angeordneten. Weiterhin weist da Leistungshalbleitermodul ein Gehäuse und von den Teilschaltungen nach außen führenden Last- und Hilfsanschlusselemente auf.

Mindestens eines dieser Lastanschlusselemente ist als ein Metallformkörper mit einem bandartigen Abschnitt mit einer Mehrzahl von diesem Abschnitt ausgehenden Kontaktfüßen und mit einer Kontakteinrichtung zur externen Verbindung ausgebildet. Es ist allerdings bevorzugt alle Lastanschlusselemente in gleicher Weise auszubilden und derart anzuordnen, dass die bandartigen Abschnitte parallel zueinander, voneinander beabstandet und elektrisch voneinander isoliert angeordnet sind und somit einen Stapel aus bilden.

Weiterhin ist der mindestens eine bandartige Abschnitt des jeweiligen Lastanschlusselements parallel zu den Leiterbahnen und von diesen beabstandet angeordnet. Zur elektrischen Kontaktierung reicht mindestens jeweils ein erster Kontaktfuß von dem bandartigen Abschnitt zu einer Leiterbahn der jeweiligen Teilschaltung. Vorzugsweise sind alle Teilschaltungen über derartige Kontaktfüße mit dem bandartigen Abschnitt des jeweiligen Lastanschlusselementes verbunden.

Erfindungsgemäß reicht ein erster Teilstrompfad von der Kontakteinrichtung des Lastanschlusselements zu einem Verteilungsbereich, als Teilbereich des bandartigen Abschnitts. Von diesem Verteilungsbereich des bandartigen Abschnitts reichen jeweils zweite Teilstrompfade zu den jeweiligen ersten Kontaktfüßen. Hierbei bilden der erste und die jeweiligen zweiten Teilstrompfad Gesamtstrompfade, zur symmetrischen Stromeinleitung in die jeweiligen Teilschaltungen, aus. Hierbei weisen die jeweiligen Gesamtstrompfade eine Längendifferenz von weniger als 20 von 100 zueinander auf. Zur Ausbildung derartiger Gesamtstrompfade weist der bandartige Abschnitt des Lastanschlusselements mindestens eine erste Freisparung auf.

Es ist hierbei bevorzugt, wenn der jeweilige bandartige Abschnitt in der Umgebung des Verteilungsbereichs mindestens bis zu den ersten Kontaktfüßen reichend vollständig symmetrisch ausgebildet ist. Hierzu ist es vorteilhaft wenn der bandartige Abschnitt mindestens eine weitere Freisparung zu Herstellung der Symmetrie aufweist.

Es kann ebenso bevorzugt sein, wenn jeder Teilschaltung weitere zueinander symmetrisch angeordnete Kontaktfüße zugeordnet sind und die weiteren Gesamtstrompfade ebenfalls eine jeweilige Längendifferenz von weniger als 20 von 100 aufweisen.

Die erfinderische Lösung wird an Hand der Ausführungsbeispiele der Fig. 1 bis 5 weiter erläutert.

Fig. 1 zeigt eine dreidimensionale Darstellung eines erfindungsgemäßen Leistungshalbleitermoduls.

Fig. 2 zeigt einen Ausschnitt eines ersten erfindungsgemäßen Leistungshalbleitermoduls in Draufsicht.

Fig. 3 zeigt einen Ausschnitt eines zweiten erfindungsgemäßen Leistungshalbleitermoduls in Draufsicht.

Fig. 4 zeigt einen Ausschnitt eines dritten erfindungsgemäßen Leistungshalbleitermoduls in Draufsicht.

Fig. 5 zeigt ein Lastanschlusselement des dritten erfindungsgemäßen Leistungshalbleitermoduls in dreidimensionaler Ansicht.

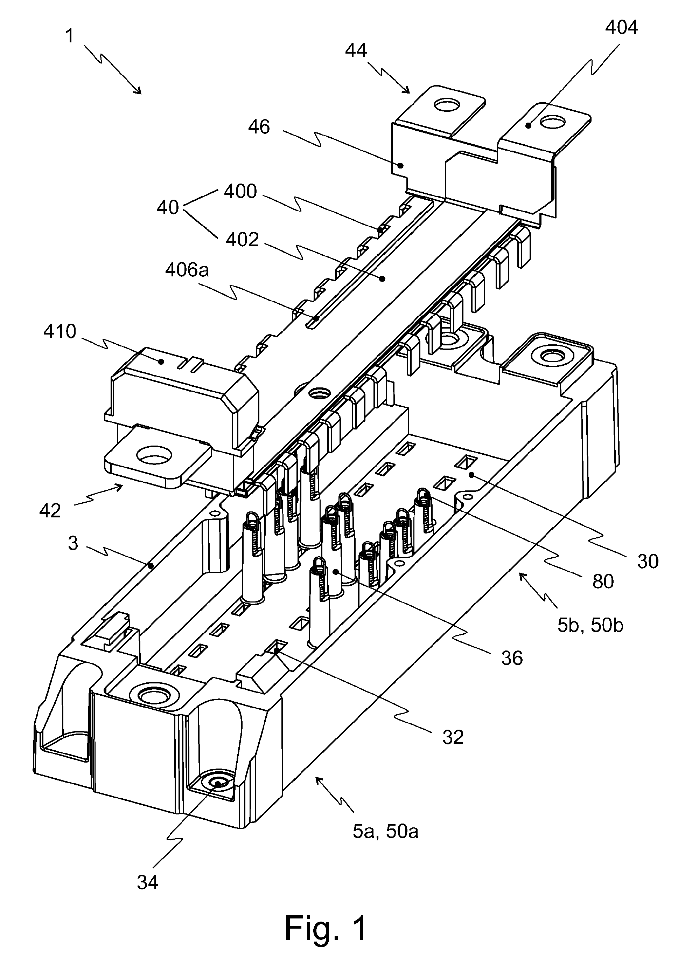

Fig. 1 zeigt eine dreidimensionale Darstellung eins erfindungsgemäßen Leistungshalbleitermoduls (1). Dargestellt ist hierbei ein Kunststoffgehäuse (3) mit Einrichtungen (34) zur Befestigung auf einem Kühlbauteil. Das Gehäuse (3) weist einen einstückig mit diesem ausgebildeten Isolierstoffformkörper (30) auf, der eine Zwischenlage bildet, zwischen dem unterhalb dieser Zwischenlage angeordneten Substraten (5 a/b) und den oberhalb dieser Zwischenlage angeordneten bandartigen Abschnitten (402) von Lastanschlusselementen (40, 42, 44).

Weiterhin weist das Gehäuse (3) domartige Durchführungen (38) für Hilfsanschlusselemente (80) auf. Es ist besonders bevorzugt in derartigen druckkontaktierten Leistungshalbleitermodulen (1) die Hilfsanschlusselemente als Kontaktfedern (80), vorzugsweise Schraubenfedern, auszubilden. Diese Hilfsanschlusselemente verbinden die Teilschaltungen mit zugeordneten, nicht dargestellten, Treiber für das Leistungshalbleitermodul (1). Hierzu weisen die bandartige Abschnitte (402) der Lastanschlusselemente (40, 42, 44) die Symmetrie nicht brechende Ausnehmungen zur Durchführung dieser Schraubenfedern auf.

Die Lastanschlusselemente (40, 42, 44) der verschiedenen Lastpotentiale sind jeweils als Metallformkörper mit einer zugeordneten Kontakteinrichtung (404) zur externen Verbindung, mindestens einem bandartigen parallel zur Substratoberfläche verlaufenden Abschnitt (402), sowie mit einer Mehrzahl von diesem Abschnitt ausgehenden Kontaktfüßen (400) ausgebildet. Die jeweiligen Lastanschlusselemente (40, 42, 44) sind soweit notwendig mittels eine isolierenden Kunststofffolie (46) voneinander beabstandet und gegeneinander elektrisch isoliert. Das Wechselstromanschlusselement (42) weist weiterhin einen benachbart zur Kontakteinrichtung angeordneten Stromsensor (410) auf.

Die Kontaktfüße (400) der Lastanschlusselemente (40, 42, 44) reichen durch die als Führungen ausgebildeten Ausnehmungen (32) des Isolierstoffformkörpers (30) zu zugeordneten Kontaktflächen der Leiterbahnen der Substrate (5 a/b) bzw. zu dort angeordneten Leistungshalbleiterbauelementen.

Mindestens einer der bandartigen Abschnitte (402) der Lastanschlusselemente (40, 42, 44) weist erfindungsgemäß eine Freisparung auf, die für eine Symmetrierung der jeweiligen Gesamtstrompfade von der Kontakteinrichtung (404) zu den auf einzelnen Substraten (5 a/b) angeordneten Teilschaltungen (50 a/b) dient. Weitere Einzelheiten sind in den folgenden Figuren beschrieben.

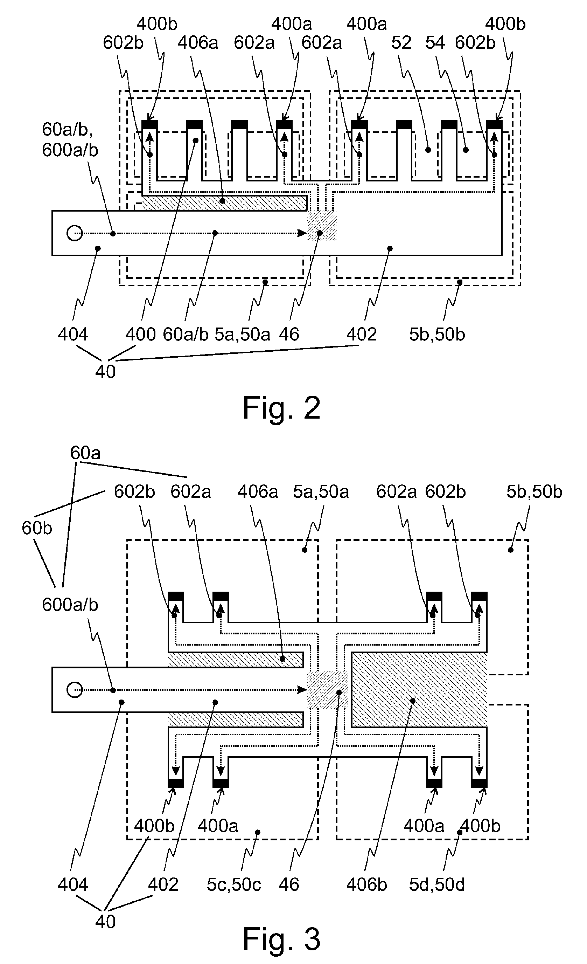

Fig. 2 zeigt einen Ausschnitt eines ersten erfindungsgemäßen Leistungshalbleitermoduls in Draufsicht. Dargestellt ist hier vornehmlich ein Lastanschlusselement (40) mit einer Kontakteinrichtung (404), die zur externen Verbindung eine Ausnehmung beispielhaft zur Anordnung einer Schraubverbindung aufweist. Im Anschluss an die Kontakteinrichtung (404) weist das Lastanschlusselement (40) einen bandartigen Abschnitt (402) auf, der parallel zu zwei Substraten (5) mit hierauf angeordneten Leiterbahnen (52) und Leistungshalbleiterbauelementen (54) angeordnet ist.

Diese Substrate (5 a/b) bilden hier die jeweiligen Teilschaltungen (50 a/b) der leistungselektronischen Schaltung des Leistungshalbleitermoduls aus. Der bandartige Abschnitt (402) des Lastanschlusselements (40) kontaktiert mittels seiner Kontaktfüße (400) die Leiterbahnen (52) beider Teilschaltungen (50).

Für eine gleichmäßige Belastung der Leistungshalbleiterbauelemente (54), die häufig in derartigen leistungselektronischen Schaltungen parallel geschaltet sind ist es wesentlich, die Stromzuführung zu symmetrisieren. Dies wird hier erfindungsgemäß erzielt indem im Verlauf des bandartigen Abschnitts (402) oberhalb der ersten Teilschaltung (50a) eine erste Freisparung (406a) angeordnet ist, wodurch der Gesamtstrompfad von der Kontakteinrichtung (404) zu den Kontaktfüßen (400a) der ersten Teilschaltung (50a) verlängert wird.

Durch diese Maßnahme ist der jeweilige erste Gesamtstrompfad (60a) von der Kontakteinrichtung (404) zu den ersten einer Teilschaltung (50 a/b) zugeordneten Kontaktfüßen (400a) bis auf eine geringe Toleranz von weniger als 20 von 100 gleich. Hierzu weist der bandartige Abschnitt (402) einen virtuellen Verteilungsbereich (46) auf der symmetrisch zu den Teilschaltungen (50 a/b) angeordnet ist. Der erste Gesamtstrompfad (60a) setzt sich aus einem ersten Teilstrompfad (600a), der von der Kontakteinrichtung (402) zum Verteilungsbereich (46) reicht und von einem zweiten Teilstrompfad (602a), der vom Verteilungsbereich (46) zu den ersten Kontaktfüßen (400a) der jeweiligen Teilschaltungen (50 a/b) reicht, zusammen.

Weiterhin dargestellt sind weitere Gesamtstrompfade (60b) zu weiteren Kontaktfüße (400b), falls eine Teilschaltung (50 a/b) nicht nur von dem ersten Kontaktfuß (400a) kontaktiert ist. Diese weiteren Gesamtstrompfade (60b) werden für jedes Paar, oder allgemeiner jede Gruppe, von weiteren Kontaktfüßen (400b) die jeweils zu einer Teilschaltung (50 a/b) zugeordnete sind gebildet aus dem ersten Teilstrompfad (600b) und dem jeweiligen zweiten Teilstrompfad (602b). Alle diese Paare oder Gruppen von weiteren Gesamtstrompfaden (60b) weisen untereinander eine jeweilige Längendifferenz von weniger als 20 von 100 auf.

Fig. 3 zeigt einen Ausschnitt eines zweiten erfindungsgemäßen Leistungshalbleitermoduls in Draufsicht. Dieses Leistungshalbleitermodul weist vier, ebenfalls auf jeweils einem Substrat (5 a/b/c/d) angeordnete, Teilschaltungen (50 a/b/c/d) auf. Auf die Darstellung der Leiterbahnen und Leistungshalbleiterbauelemente wird hier aus Übersichtlichkeitsgründen verzichtet.

Das Lastanschlusselement (40) besteht wiederum aus der Kontakteinrichtung (404), dem bandartigen Abschnitt (402) und den Kontaktfüßen (400). Der jeweils erste Teilstrompfand (600a) reicht von dem Lastanschlusselement (404) zu einem zentral auf dem bandartigen Abschnitt (402) angeordneten Verteilungsbereich (46). Von diesem aus reichen zweite Teilstrompfade (602a) zu allen eigenen Teilschaltungen (50 a/b) zugeordneten ersten Kontaktfüßen (400a). Die ersten Freisparungen (46) des bandartigen Abschnitts (402) sind derart angeordnet, dass diese zweiten Teilstrompfade (602a), die in der Summe mit dem jeweiligen ersten Teilstrompfad (600a) jeweils einen ersten Gesamtstrompfad (60a) bilden und diese eine Längendifferenz von weniger als 20 von 100 zueinander aufweisen.

Durch diese Ausgestaltung ist der bandartige Abschnitt (402) in der Umgebung des Verteilungsbereichs (46) mindestens bis zu den ersten Kontaktfüßen (400a) reichend symmetrisch ausgebildet ist wozu eine weitere erste Freisparung (406b) in dem bandartigen Abschnitt (402) vorgesehen ist. Wobei für diese Symmetrie derjenige Bereiche des bandartigen Abschnitts (402) wesentlich sind, in denen die zweiten Teilstrompfade (602a) verlaufen.

Ebenfalls dargestellt sind weitere Gesamtstrompfade (60b) zu weiteren Kontaktfüße (400b) die wiederum symmetrisch zur Lage des Verteilungsbereichs (46) angeordnet sind. Auch diese weiteren Gesamtstrompfade (60b) weisen eine jeweilige Längendifferenz von weniger als 20 von 100 auf.

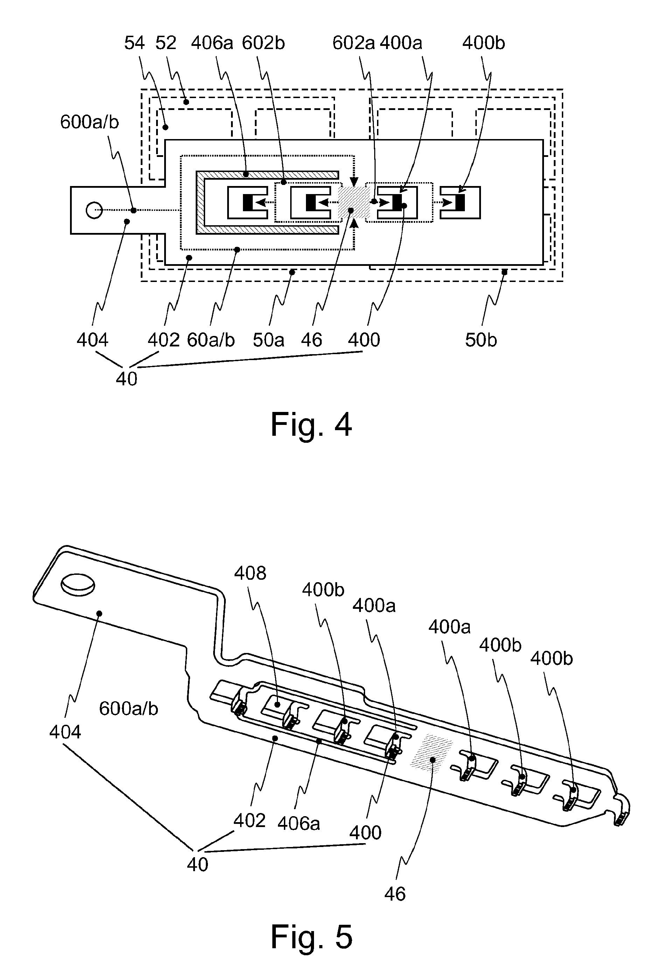

Fig. 4 zeigt einen Ausschnitt eines dritten erfindungsgemäßen Leistungshalbleitermoduls in Draufsicht. Im Unterschied zur Ausbildung gemäß Fig. 2 stehen hier die Kontaktfüße (400) nicht seitlich von dem bandartigen Abschnitt (402) des Lastanschlusselements (400) weg sondern werden quasi aus diesem ausgebildet. Hierzu weist der bandartige Abschnitt (402) zweite Feisparungen (408) auf, wobei die Kontaktfüße (400) durch Wegbiegen des frei gesparten Materials, vgl. hierzu auch Fig. 5, ausgebildet sind.

Weiterhin unterscheidet sich diese Ausgestaltung von derjenigen gemäß Fig. 2 dadurch dass die beiden Teilschaltungen (50 a/b) auf einem gemeinsamen Substrat (5) angeordnet sind. Im Übrigen weiset dieses wiederum einen isolierenden Grundkörper und hierauf angeordneten Leiterbahnen (52) auf. Auf diesen Leiterbahnen (52) sind die Leistungshalbleiterbauelemente (54) angeordnet.

Zur symmetrischen Stromversorgung weist der bandartige Abschnitt (402) des Lastanschlusselements (40) wiederum eine erste U-förmige um die der ersten Teilschaltung (50a) zugeordneten Kontaktfüßen (400 a/b) angeordnete Freisparung (406a) auf. Diese bewirkt, dass der Strom in einem ersten Teilstrompfad (60a) erst zu dem Verteilungsbereich (46) fließen muss um dann von dort in zweiten symmetrisch zum Verteilungsbereich (46) ausgebildeten Teilstrompfaden (602a) zu den jeweiligen ersten Kontaktfüßen (400a) fließen kann. Analoges gilt für weitere Gesamtstrompfade (60b) zu weiteren Kontaktfüßen (400b). Somit werden auch in dieser Ausbildung für die jeweiligen Kontaktfußpaare Gesamtstrompfade (60 a/b) erreicht, die eine Längendifferenz von weniger als 20 von 100 aufweist. Diese Symmetrie, mit einer Toleranz von 20 von 100 gilt allgemein jeweils für die ersten Kontaktfüße sowie für die Paare, oder bei mehr als zwei Teilschaltungen entsprechenden Gruppen, weiterer Kontaktfüße

Fig. 5 zeigt ein Lastanschlusselement (40) des dritten erfindungsgemäßen Leistungshalbleitermoduls in dreidimensionaler Ansicht, wobei alle wesentlichen Merkmale unter Fig. 4 bereits beschrieben sind. In dieser Ausgestaltung wird die einstückige Ausbildung des bandartigen Abschnitts (402) und der Kontaktfüße (400 a/b) verdeutlicht.

## Patentansprüche

1. Leistungshalbleitermodul (1), zur Anordnung auf einem Kühlbauteil, mit mindestens zwei leistungselektronischen Teilschaltungen (50 a/b/c/d), jeweils mit mindestens einem auf Leiterbahnen (52) mit Lastpotential der Teilschaltungen angeordneten Leistungshalbleiterbauelemente (54), einem Gehäuse (3) und nach außen führenden Last- (40, 42, 44) und Hilfsanschlusselementen (80)
wobei mindestens ein Lastanschlusselement (40, 42, 44) als Metallformkörper mit einem bandartigen Abschnitt (402) mit einer Mehrzahl von diesem Abschnitt ausgehenden Kontaktfüßen (400 a/b) und mit einer Kontakteinrichtung (404) zur externen Verbindung ausgebildet ist, dieser bandartige Abschnitt (402) parallel zu den Leiterbahnen und von diesen beabstandet angeordnet ist und mindestens jeweils ein erster Kontaktfuß (400a) von dem bandartigen Abschnitt (402) zur elektrischen Kontaktierung zu einer Leiterbahnen der jeweiligen Teilschaltung (50) reicht wobei ein erster Teilstrompfad (600a) von der Kontakteinrichtung (404) zu einem Verteilungsbereich (46) des bandartigen Abschnitts (402) reicht und jeweils zweite Teilstrompfade (602a) vom Verteilungsbereich (46) zu den jeweiligen ersten Kontaktfüßen (400a) reichen und die jeweiligen ersten Gesamtstrompfade (60a), zur symmetrischen Stromeinleitung in die jeweiligen Teilschaltungen (50 a/b), gebildet sind aus dem ersten (600a) und zweiten (602a) Teilstrompfad, wobei die jeweiligen Gesamtstrompfade (60a) eine Längendifferenz von weniger als 20 von 100 zueinander aufweisen und wobei der bandartige Abschnitt (402) hierzu mindestens eine erste Freisparung (406a) aufweist.

2. Leistungshalbleitermodul nach Anspruch 1,
wobei jede Teilschaltung (50 a/b) als ein Substrat (5) mit einem isolierenden Grundkörper und hierauf angeordneten Leiterbahnen (52) ausgebildet ist.

3. Leistungshalbleitermodul nach Anspruch 1,
wobei der bandartige Abschnitt (402) in der Umgebung des Verteilungsbereichs (46) mindestens bis zu den ersten Kontaktfüßen (400a) reichend symmetrisch ausgebildet ist und hierzu mindestens eine weitere erste Freisparung (406b) in dem bandartigen Abschnitt vorgesehen ist.

4. Leistungshalbleitermodul nach Anspruch 1,
wobei jeder Teilschaltung (50 a/b) weitere zueinander symmetrisch angeordnete Kontaktfüße (400b) zugeordnet sind und die weiteren Gesamtstrompfade (60b) ebenfalls eine jeweilige Längendifferenz von weniger als 20 von 100 aufweisen.

5. Leistungshalbleitermodul nach Anspruch 1,
wobei der bandartige Abschnitt (402) und die Kontaktfüße (400) einstückig ausgebildet sind.

6. Leistungshalbleitermodul (1) nach Anspruch 1
wobei der mindestens eine bandartige Abschnitt (402) der Lastanschlusselemente (40, 42, 44) Ausnehmungen zur Durchführung von als Schraubenfedern ausgebildeten Hilfsanschlusselemente (80) aufweisen.

7. Leistungshalbleitermodul nach Anspruch 1,
wobei eine Mehrzahl gleichartiger Lastanschlusselemente (40, 42, 44) vorgesehen sind und deren bandartige Abschnitte parallel zueinander, voneinander beabstandet und elektrisch voneinander isoliert angeordnet sind und einen Stapel bilden.

8. Leistungshalbleitermodul (1) nach Anspruch 1
wobei eine Druckeinrichtung auf den mindestens einen bandartigen Abschnitt (402) der Lastanschlusselemente (40, 42, 44) und hierüber auf die Kontaktfüße (400) Druck ausübt zu deren elektrisch leitender Verbindung mit zugeordneten Leiterbahnen oder Leistungshalbleiterbauelementen auf dem Substrat (5 a/b).
